(19) Europäisches Patentamt
European Patent Office
Office européen des brevets

(11) **EP 4 294 141 A1**

(12) **EUROPEAN PATENT APPLICATION**

(43) Date of publication:
**20.12.2023 Bulletin 2023/51**

(21) Application number: **23178890.2**

(22) Date of filing: **13.06.2023**

(51) International Patent Classification (IPC):
**H05K 9/00** (2006.01)  **H01Q 15/00** (2006.01)

(52) Cooperative Patent Classification (CPC):
**H05K 9/0081; H01Q 15/0006**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.06.2022 JP 2022096640**

(71) Applicant: **Nitto Denko Corporation**
**Ibaraki-shi, Osaka 567-8680 (JP)**

(72) Inventor: **Matsuzaki, Yuya**
**Ibaraki-shi, Osaka, 567-8680 (JP)**

(74) Representative: **Grünecker Patent- und Rechtsanwälte**
**PartG mbB**
**Leopoldstraße 4**
**80802 München (DE)**

(54) **ELECTROMAGNETIC SHIELD**

(57)     An electromagnetic shield 1a has a first surface 11 and a second surface 12. The electromagnetic shield 1a includes a dielectric. The first surface 11 is a surface configured to allow an electromagnetic wave to be incident on the first surface 11. The second surface 12 is a surface configured to allow at least a portion of the electromagnetic wave incident on the first surface to emerge from the second surface 12. When an electromagnetic wave $W_{EM}$ is transmitted to be incident on the first surface at incident angles of 45°, 60°, and 75°, the electromagnetic shield 1a satisfies at least one requirement selected from the group consisting of (I-1), (I-2), and (I-3) below.

$$10\mathrm{Log}|P_{R45}/P_{T45}| \geq 5.0 \, [\mathrm{dB}] \quad (I\text{-}1)$$

$$10\mathrm{Log}|P_{R60}/P_{T60}| \geq 5.0 \, [\mathrm{dB}] \quad (I\text{-}2)$$

$$10\mathrm{Log}|P_{R75}/P_{T75}| \geq 5.0 \, [\mathrm{dB}] \quad (I\text{-}3)$$

FIG. 1A

**Description**

BACKGROUND OF THE INVENTION

1. Field of the Invention

The present invention relates to an electromagnetic shield.

2. Description of Related Art

Using radio wave absorbers for blocking electromagnetic waves have been known.

For example, JP 6901629 B2 and JP 6901630 B2 each describe a radio wave absorber including a support, a resistive film, a dielectric layer, and a reflective layer. These radio wave absorbers exhibit a given capability to absorb a TM polarized wave, a TE polarized wave, or a circularly polarized wave which is incident thereon at 45°.

SUMMARY OF THE INVENTION

The radio wave absorbers described in JP 6901629 B2 and JP 6901630 B2 each include a support, a resistive film, a dielectric layer, and a reflective layer. For example, it is understood that the resistive film needs to have a given resistance value and that a member, such as a metal film, capable of reflecting a radio wave needs to be used as the reflective layer. Therefore, the radio wave absorbers described in JP 6901629 B2 and JP 6901630 B2 leave room for review from the viewpoint of achieving a simpler configuration capable of blocking an electromagnetic wave that is obliquely incident thereon.

Therefore, the present invention provides an electromagnetic shield that is advantageous from the viewpoint of achieving a simple configuration capable of blocking an electromagnetic wave that is obliquely incident thereon.

The present invention provides an electromagnetic shield including:

a dielectric, wherein
the electromagnetic shield has a first surface and a second surface, the first surface being configured to allow an electromagnetic wave to be incident on the first surface, the second surface being configured to allow at least a portion of the electromagnetic wave incident on the first surface to emerge from the second surface, and
when an electromagnetic wave $W_{EM}$ having at least one frequency in a range of 10 GHz to 300 GHz is transmitted to be incident on the first surface at incident angles of 45°, 60°, and 75°, the electromagnetic shield satisfies at least one first requirement selected from the group consisting of (I-1), (I-2), and (I-3) below:

$$|10Log(P_{R45}/P_{T45})| \geq 5.0 \text{ [dB]} \qquad \text{(I-1)};$$

$$|10Log(P_{R60}/P_{T60})| \geq 5.0 \text{ [dB]} \qquad \text{(I-2)};$$

and

$$|10Log(P_{R75}/P_{T75})| \geq 5.0 \text{ [dB]} \qquad \text{(I-3)},$$

in the first requirements,
$P_{T45}$ is an electric power [W] of the electromagnetic wave $W_{EM}$ transmitted such that the incident angle is 45°,
$P_{R45}$ is an electric power [W] of an electromagnetic wave received on a receiving plane when the electromagnetic wave $W_{EM}$ is transmitted such that the incident angle is 45°, the receiving plane including an end point of a first line segment extending from an incident point of the electromagnetic wave $W_{EM}$ on the electromagnetic shield toward an outside of the electromagnetic shield in a direction parallel to an incident direction of the electromagnetic wave $W_{EM}$, the first line segment intersecting with the second surface, the end point being located in the outside,
$P_{T60}$ is an electric power [W] of the electromagnetic wave $W_{EM}$ transmitted such that the incident angle is 60°,
$P_{R60}$ is an electric power [W] of an electromagnetic wave received on a receiving plane when the electromagnetic wave $W_{EM}$ is transmitted such that the incident angle is 60°, the receiving plane including an end point of a second line segment extending from the incident point of the electromagnetic wave $W_{EM}$ on the electromagnetic shield toward the outside of the electromagnetic shield in a direction parallel to an incident direction of the electromagnetic wave $W_{EM}$, the second line segment intersecting with the second surface, the end point being located in the outside, $P_{T75}$ is an electric power [W] of the electromagnetic wave $W_{EM}$ transmitted such that the incident angle is 75°, and $P_{R75}$ is an electric power [W] of an electromagnetic wave received on a receiving plane when the electromagnetic wave $W_{EM}$ is transmitted such that the incident angle is 75°, the receiving plane including an end point of a third line segment extending from the incident point of the electromagnetic wave $W_{EM}$ on the electromagnetic shield toward the outside of the electromagnetic shield in a direction parallel to an incident direction of the electromagnetic wave $W_{EM}$, the third line segment intersecting with the second surface, the end point being located in the outside.

The above electromagnetic shield is advantageous from the viewpoint of achieving a simple configuration capable of blocking an electromagnetic wave that is obliquely incident thereon.

BRIEF DESCRIPTION OF THE DRAWING

FIG. 1A is a perspective view of an example of the electromagnetic shield according to the present invention.
FIG. 1B is a side view of the electromagnetic shield shown in FIG. 1A.
FIG. 1C is a plan view of the electromagnetic shield shown in FIG. 1A.
FIG. 2 illustrates requirements satisfied by the electromagnetic shield shown in FIG. 1A.
FIG. 3 is a plan view of another example of the electromagnetic shield according to the present invention.
FIG. 4 is a side view of yet another example of the electromagnetic shield according to the present invention.
FIG. 5A shows how to measure a return loss.
FIG. 5B shows how to measure a transmission loss.
FIG. 6 is a perspective view schematically showing an analysis model.
FIG. 7 is a perspective view showing an analysis model of an electromagnetic shield according to a comparative example.
FIG. 8A shows a graph of a relation between a transmission loss T and a ratio $S_{pa}/S_e$.
FIG. 8B shows a graph of a relation between a transmission loss T and a ratio $S_p/S_e$.
FIG. 8C shows a graph of a relation between a transmission loss T and a ratio $S_p/S_e$.

DETAILED DESCRIPTION OF THE INVENTION

Embodiments of the present invention will be described with reference to the drawings. The present invention is not limited to the embodiments described below. In the accompanying drawings, the x axis, the y axis, and the z axis are orthogonal to each other.

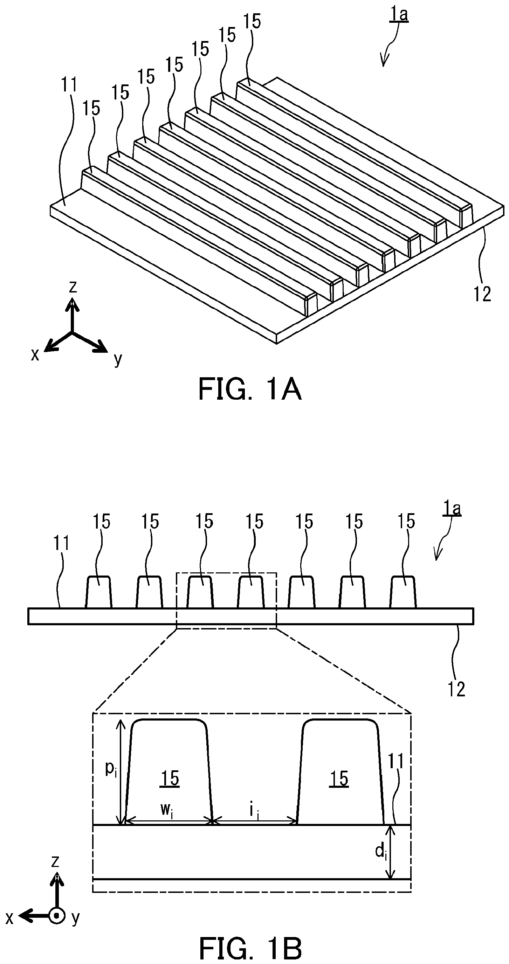

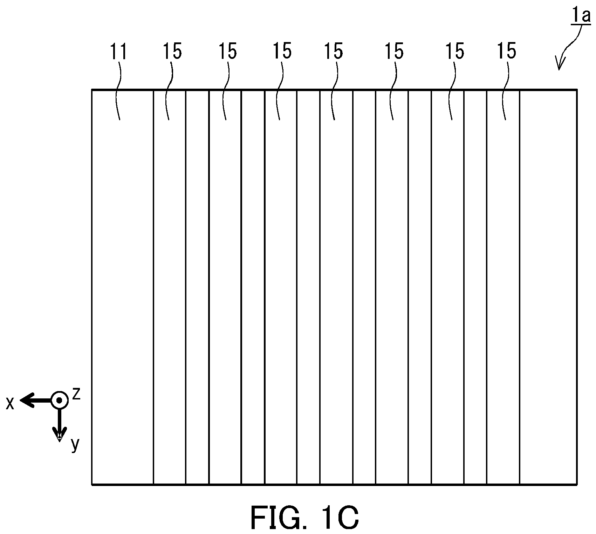

As shown in FIGS. 1A, 1B, and 1C, an electromagnetic shield 1a has a first surface 11 and a second surface 12. The electromagnetic shield 1a includes a dielectric. The first surface 11 is a surface configured to allow an electromagnetic wave to be incident on the first surface 11. The first surface 11 is, for example, a flat surface. The second surface 12 is a surface configured to allow at least a portion of the electromagnetic wave incident on the first surface 11 to emerge from the second surface 12. The second surface 12 is, for example, a flat surface.

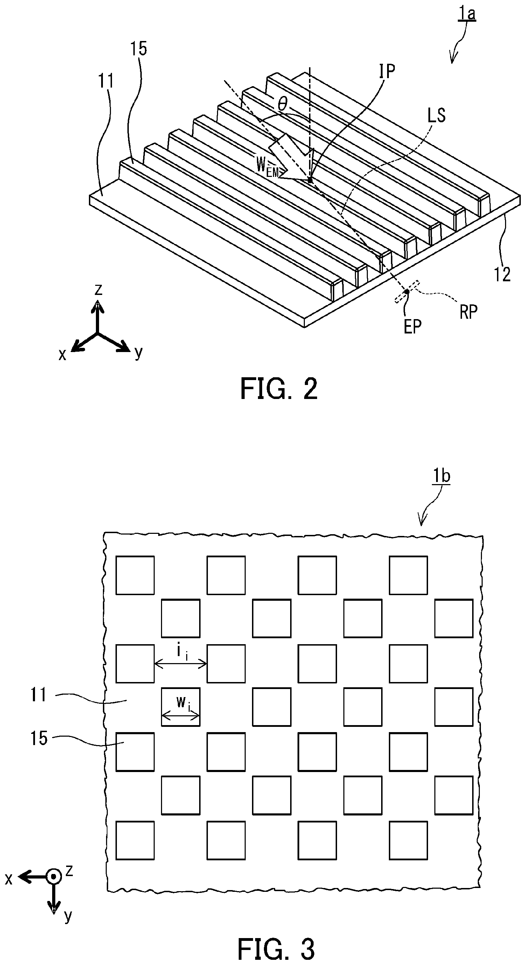

FIG. 2 illustrates requirements satisfied by the electromagnetic shield 1a. When an electromagnetic wave $W_{EM}$ is transmitted to be incident on the first surface 11 at incident angles $\theta$ of 45°, 60°, and 75°, the electromagnetic shield 1a satisfies at least one requirement selected from the group consisting of (I-1), (I-2), and (I-3) below. The electromagnetic wave $W_{EM}$ has at least one frequency in a range of 10 GHz to 300 GHz. In the following requirements, $P_{T45}$ is an electric power [W] of the electromagnetic wave $W_{EM}$ transmitted such that the incident angle $\theta$ is 45°. $P_{R45}$ is an electric power [W] of an electromagnetic wave received on a receiving plane RP when the electromagnetic wave $W_{EM}$ is transmitted such that the incident angle $\theta$ is 45°. $P_{T60}$ is an electric power [W] of the electromagnetic wave $W_{EM}$ transmitted such that the incident angle $\theta$ is 60°. $P_{R60}$ is an electric power [W] of an electromagnetic wave received on the receiving plane RP when the electromagnetic wave $W_{EM}$ is transmitted such that the incident angle $\theta$ is 60°. $P_{T75}$ is an electric power [W] of the electromagnetic wave $W_{EM}$ transmitted such that the incident angle $\theta$ is 75°. $P_{R75}$ is an electric power [W] of an electromagnetic wave received on the receiving plane RP when the electromagnetic wave $W_{EM}$ is transmitted such that the incident angle $\theta$ is 75°. In each of the cases where the incident angle $\theta$ of the electromagnetic wave $W_{EM}$ is 45°, 60°, and 75°, the receiving plane RP includes an end point EP of a line segment LS, the end point EP being located in an outside of the electromagnetic shield 1a. The line segment LS extends from an incident point IP of the electromagnetic wave $W_{EM}$ on the electromagnetic shield 1a to the end point EP in a direction parallel to an incident direction of the electromagnetic wave $W_{EM}$ and intersects with the second surface 12. In (I-1), (I-2), and (I-3) below, "Log" represents a common logarithm. The incident point IP is an incident point, for example, corresponding to the center of a beam of the electromagnetic wave $W_{EM}$. The electromagnetic wave $W_{EM}$ has, for example, a beam diameter of 30 mm. The receiving plane RP is a 30 mm diameter circle having its center at the end point EP and perpendicular to the line segment LS. A distance between the end point EP and the electromagnetic shield 1a is, for example, 100 mm or longer.

$$|10Log(P_{R45}/P_{T45})| \geq 5.0 \text{ [dB]} \qquad \text{(I-1)}$$

$$|10Log(P_{R60}/P_{T60})| \geq 5.0 \text{ [dB]} \qquad \text{(I-2)}$$

$$|10Log(P_{R75}/P_{T75})| \geq 5.0 \text{ [dB]} \qquad \text{(I-3)}$$

Each of the electric powers $P_{T45}$, $P_{T60}$, and $P_{T75}$ represents an electric power of the transmitted electromagnetic wave $W_{EM}$, as described above. It is possible to measure the electric powers $P_{T45}$, $P_{T60}$, and $P_{T75}$, for example, by transmitting the electromagnetic wave $W_{EM}$ and receiving the electromagnetic wave $W_{EM}$ on the receiving plane RP without setting the electromagnetic shield 1a. Therefore, the electric powers $P_{T45}$, $P_{T60}$, and $P_{T75}$ do not need to be electric powers directly measured for the transmitted electromagnetic wave $W_{EM}$.

The electromagnetic wave $W_{EM}$ transmitted to be incident on the electromagnetic shield 1a satisfying at least one requirement selected from the group consisting of the above requirements (I-1), (I-2), and (I-3) is not limited to a particular type of electromagnetic wave. The electromagnetic wave $W_{EM}$ may be a transverse magnetic wave (TM wave), a transverse electric wave (TE wave), a circularly polarized wave, or another type of radio wave. For example, when at least one electromagnetic wave selected from the group consisting of a TM wave, a TE wave, and a circularly polarized wave is incident on the electromagnetic shield 1a, at least one requirement selected from the group consisting of the above requirements (I-1), (I-2), and (I-3) can be satisfied.

As described above, the second surface 12 of the electromagnetic shield 1a allows at least a portion of the electromagnetic wave incident on the first surface 11 to emerge therefrom. However, since the electromagnetic shield 1a satisfies at least one requirement selected from the group consisting of the above requirements (I-1), (I-2), and (I-3), the electromagnetic shield 1a is advantageous from the viewpoint of blocking an electromagnetic wave that is obliquely incident thereon. Moreover, the electromagnetic shield 1a is just required to include the dielectric, and can satisfy the above requirement(s) even without materials other than the dielectric. Therefore, the electromagnetic shield 1a is advantageous from the viewpoint of achieving a simple configuration capable of blocking an electromagnetic wave that is obliquely incident thereon. The term "electromagnetic shield" herein refers to an article that can exhibit a function of attenuating the energy of an electromagnetic wave. The principle on which an electromagnetic shield attenuates the energy of an electromagnetic wave is not limited to a particular principle. The principle can be, for example, one using a phenomenon, such as reflection, transmission, absorption, diffraction, or interference, accompanying an interaction between an electromagnetic wave and an electromagnetic shield and a phenomenon, such as scattering or diffusion of the electromagnetic wave, caused by the above phenomenon.

The electromagnetic shield 1a desirably satisfies both the requirement (I-1) and the requirement (I-2). In this case, the electromagnetic shield 1a easily blocks electromagnetic waves obliquely incident thereon at various incident angles to prevent the electromagnetic waves from exerting an influence on a specific region.

The electromagnetic shield 1a is, for example, free of an electrically conductive portion. For blocking an electromagnetic wave, for example, an electrically conductive portion such as a metal film may be used to reflect an electromagnetic wave. However, the electromagnetic shield 1a can satisfy at least one requirement selected from the group consisting of the above requirements (I-1), (I-2), and (I-3) without an electrically conductive portion. Therefore, a simple configuration capable of blocking an electromagnetic wave that is obliquely incident thereon is easily achieved. The electromagnetic shield 1a may consist of the dielectric, or may include an electrically conductive portion.

An imaginary part $\varepsilon''$ of a relative permittivity of the dielectric included in the electromagnetic shield 1a is not limited to a particular value. For example, the imaginary part $\varepsilon''$ of the relative permittivity of the dielectric at at least one frequency $f_g$ in a range of 10 GHz to 300 GHz is 0.1 or less. It appears that the imaginary part $\varepsilon''$ of the dielectric is desirably large in the case of attenuating an electromagnetic wave using a dielectric loss. However, even if the imaginary part $\varepsilon''$ of the relative permittivity of the dielectric is as small as 0.1 or less, at least one requirement selected from the group consisting of the above requirements (I-1), (I-2), and (I-3) can be satisfied by the electromagnetic shield 1a by adjusting a phenomenon caused by an interaction between the electromagnetic shield 1a and an electromagnetic wave. The imaginary part $\varepsilon''$ may be 0.05 or less, or 0.01 or less.

A real part $\varepsilon'$ of the relative permittivity of the dielectric included in the electromagnetic shield 1a is not limited to a particular value. For example, the real part $\varepsilon'$ of the relative permittivity of the dielectric at the frequency $f_g$ is 2.0 to 4.0. Even in this case, at least one requirement selected from the group consisting of the above requirements (I-1), (I-2), and (I-3) can be satisfied by the electromagnetic shield 1a by adjusting a phenomenon caused by an interaction between the electromagnetic shield 1a and an electromagnetic wave. The real part $\varepsilon'$ may be 3.8 or less, 3.6 or less, 3.4 or less, 3.2 or less, 3.0 or less, 2.8 or less, 2.6 or less, or 2.4 or less.

The material of the dielectric included in the electromagnetic shield 1a is not limited to a particular one. The dielectric is made of, for example, a resin. The resin is, for example, a thermoplastic resin. Examples of the resin include polyethylene, polypropylene, polyvinyl alcohol, polyethylene terephthalate, polybutylene terephthalate, ethylene-vinyl acetate copolymer, polystyrene, acrylonitrile styrene, acrylonitrile-butadiene-styrene copolymer, ASA resin, AES resin, acrylic resins such as PMMA, MS resin, MBS resin, cycloolefin resin, polyacetal resin, polyamide resin, polyester resin, polycarbonate resin, polyurethane resin, liquid crystal polymer, EPDM, PPS, PEEK, PPE, polysulfone-based resin, polyimide-based resin, fluorine resin, thermoplastic elastomers such as olefin-based thermoplastic elastomer (TPO), and acrylic elastomers. The resin may be a thermosetting resin. The thermosetting resin is, for example, an epoxy resin, an acrylic resin, or a silicone resin. The dielectric may include only one resin or two or more resins.

The electromagnetic shield 1a may include, for example, a filler. The filler may be a colorant such as carbon black, an inorganic reinforcement such as talc, glass fibers, or a mineral, or a softener. The electromagnetic shield 1a may include an additive such as a flame retardant or a plasticizer. The electromagnetic shield 1a may be free of a filler. In this case, the cost of manufacturing the electromagnetic shield 1a is likely to be low.

As shown in FIGS. 1A, 1B, and 1C, the electromagnetic shield 1a includes, for example, a plurality of projecting portions 15. The plurality of projecting portions 15 project, for example, from the first surface 11 in a direction away from the second surface 12. The plurality of projecting portions 15 may project from the second surface 12 in a direction away from the first surface 11. The electromagnetic shield 1a configured in such a manner is likely to satisfy at least one requirement selected from the group consisting of the above requirements (I-1), (I-2), and (I-3) even with a simple configuration.

The electromagnetic shield 1a can be used, for example, as an electromagnetic shield for millimeter-wave radars, millimeter-wave radio communication, millimeter-wave sensing, or the like. A device including the electromagnetic shield 1a can be used, for example, in automobiles and wireless base stations. When the electromagnetic shield 1a is for millimeter-wave radars, the electromagnetic shield 1a can be included in a millimeter-wave radar using one frequency band selected from the group consisting of the 24 GHz band, the 60 GHz band, the 76 GHz band, and the 79 GHz band. The electromagnetic shield 1a is not just for blocking only an electromagnetic wave with a particular wavelength, and may block electromagnetic waves in a wide wavelength region. It is also possible to regard an electromagnetic wave with a particular wavelength $\lambda$ as a "shielding target" of the electromagnetic shield 1a. For example, in the case of the electromagnetic shield installed with a vehicle-mounted millimeter-wave radar configured to irradiate an object with an electromagnetic wave practically having frequencies of 76 to 77 GHz, i.e., having practical irradiation wavelengths of 3.89 to 3.94 mm, 3.92 mm which is the wavelength of the center frequency, 76.5 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 77 to 81 GHz, i.e., using an electromagnetic wave having wavelengths of 3.70 to 3.89 mm, 3.79 mm, which is the wavelength of the center frequency, 79 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 24.05 to 24.25 GHz, i.e., using an electromagnetic wave having wavelengths of 12.36 to 12.47 mm, 12.41 mm, which is the wavelength of the center frequency, 24.15 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 60.0 to 60.1 GHz, i.e., using an electromagnetic wave having wavelengths of 4.99 to 5.00 mm, 4.99 mm, which is the wavelength of the center frequency, 60.05 GHz, can be understood as the wavelength $\lambda$, namely, the shielding target of this electromagnetic shield. In the case where the electromagnetic shield is for millimeter-wave radio communication using an electromagnetic wave having frequencies of 27 to 29.5 GHz, i.e., using an electromagnetic wave having wavelengths of 10.16 to 11.10 mm, 10.61 mm, which is the wavelength of the center frequency, 28.25 GHz, can be understood as the wavelength $\lambda$, namely, the shielding target of this electromagnetic shield. In the case where the electromagnetic shield is, for example, sold with a label saying that its supporting frequencies are 70 to 90 GHz, i.e., its supporting wavelengths are 3.33 to 4.28 mm, 3.75 mm, which is the wavelength of the center frequency, 80 GHz, can be understood as the wavelength $\lambda$, namely, the shielding target of this electromagnetic shield.

A projection length $p_i$ of the projecting portion 15 is not limited to a particular value. The projection length $p_i$ is a dimension of the projecting portion 15 in a projecting direction of the projecting portion 15. When the projection length $p_i$ is compared with the above-described particular wavelength $\lambda$, namely, the shielding target of the electromagnetic shield, at least one of the projection lengths $p_i$ of the plurality of projecting portions 15 satisfies a requirement, for example, $0.25\lambda \leq p_i \leq 1.3\lambda$. Because of this, the electromagnetic shield 1a is likely to exhibit desired shielding performance when an electromagnetic wave with a wavelength $\lambda$ is obliquely incident on the electromagnetic shield 1a. As shown in FIG. 1B, in the electromagnetic shield 1a, the projecting portion 15 projects in a direction perpendicular to the first surface 11.

The projection length $p_i$ may be $0.30\lambda$ or more, $0.35\lambda$ or more, $0.40\lambda$ or more, $0.45\lambda$ or more, or $0.50\lambda$ or more.

The projection length $p_i$ may be $1.2\lambda$ or less, $1.1\lambda$ or less, $1.0\lambda$ or less, or $0.9\lambda$ or less.

Fifty percent or more of the plurality of projecting portions 15 on a number basis satisfy, for example, the requirement $0.25\lambda \leq p_i \leq 1.3\lambda$. Sixty percent or more of the projecting portions 15 on a number basis may satisfy the requirement $0.25\lambda \leq p_i \leq 1.3\lambda$. Seventy percent or more of the projecting portions 15 on a number basis may satisfy the requirement $0.25\lambda \leq p_i \leq 1.3\lambda$. Eighty percent or more of the projecting portions 15 on a number basis may satisfy the requirement $0.25\lambda \leq p_i \leq 1.3\lambda$. Ninety percent or more of the projecting portions 15 on a number basis may satisfy the requirement $0.25\lambda \leq p_i \leq 1.3\lambda$. All projecting portions 15 may satisfy the requirement $0.25\lambda \leq p_i \leq 1.3\lambda$.

A width $w_i$ of the projecting portion 15 is not limited to a particular value. The width $w_i$ is a dimension of an outline of the projecting portion 15 viewed in a direction opposite to the projecting direction of the projecting portion 15, the dimension being measured in a direction in which a distance between a pair of parallel straight lines sandwiching and in contact with the outline is shortest. When the width $w_i$ is compared with the above-described particular wavelength $\lambda$, namely, the shielding target of the electromagnetic shield, at least one of the widths $w_i$ of the plurality of projecting portions 15 satisfies a requirement, for example, $0.51 \lambda \leq w_i \leq 1.6\lambda$. Because of this, the electromagnetic shield 1a is likely to exhibit desired shielding performance when an electromagnetic wave with a wavelength $\lambda$ is obliquely incident on the electromagnetic shield 1a.

The width $w_i$ may be $0.55\lambda$ or more, $0.60\lambda$ or more, $0.65\lambda$ or more, $0.70\lambda$ or more, or $0.75\lambda$ or more. The width $w_i$ may be $1.5\lambda$ or less, $1.4\lambda$ or less, $1.3\lambda$ or less, $1.2\lambda$ or less, $1.1\lambda$ or less, or $1.0\lambda$ or less.

Fifty percent or more of the plurality of projecting portions 15 on a number basis satisfy, for example, the requirement $0.51\lambda \leq w_i \leq 1.6\lambda$. Sixty percent or more of the projecting portions 15 on a number basis may satisfy the requirement $0.51\lambda \leq w_i \leq 1.6\lambda$. Seventy percent or more of the projecting portions 15 on a number basis may satisfy the requirement $0.51\lambda \leq w_i \leq 1.6\lambda$. Eighty percent or more of the projecting portions 15 on a number basis may satisfy the requirement $0.51\lambda \leq w_i \leq 1.6\lambda$. Ninety percent or more of the projecting portions 15 on a number basis may satisfy the requirement $0.51\lambda \leq w_i \leq 1.6\lambda$. All projecting portions 15 may satisfy the requirement $0.51\lambda \leq w_i \leq 1.6\lambda$.

An interval $i_i$ between the projecting portions 15 adjacent each other is not limited to a particular value. The interval $i_i$ is the shortest distance between the projecting portions 15 in a direction parallel to the first surface 11 or the second surface 12. When the interval $i_i$ is compared with the above-described particular wavelength $\lambda$, namely, the shielding target of the electromagnetic shield, the interval $i_i$ satisfies a requirement, for example, $0.51 \lambda \leq w_i \leq 1.6\lambda$. Because of this, the electromagnetic shield 1a is likely to exhibit desired shielding performance when an electromagnetic wave with a wavelength $\lambda$ is obliquely incident on the electromagnetic shield 1a.

The interval $i_i$ may be $0.55\lambda$ or more, $0.60\lambda$ or more, $0.65\lambda$ or more, $0.70\lambda$ or more, or $0.75\lambda$ or more. The interval $i_i$ may be $1.5\lambda$ or less, $1.4\lambda$ or less, or $1.3\lambda$ or less.

The shape of the projecting portion 15 is not limited to a particular one. The projecting portion 15 has a shape of, for example, at least one selected from the group consisting of a circle, a triangle, a quadrilateral, and a polygon having five or more corners when the first surface 11 or the second surface 12 is viewed in plan. As shown in FIG. 1C, the projecting portion 15 in the electromagnetic shield 1a is, for example, rectangle when the first surface 11 is viewed in plan.

The projecting portion 15 is formed in the shape of, for example, at least one selected from the group consisting of a cylinder, a prism, a cone, a pyramid, a truncated cone, and a truncated pyramid. The projecting portion 15 may be formed in the shape of a strip.

Arrangement of the plurality of projecting portions 15 is not limited to particular arrangement. Arrangement of the plurality of projecting portions 15 is, for example, at least one selected from the group consisting of arrangement at lattice points, arrangement on parallel lines, and random arrangement when the first surface 11 or the second surface 12 is viewed in plan. Because of this, the electromagnetic shield 1a is likely to exhibit desired shielding performance over a wide area thereof when an electromagnetic wave with a wavelength $\lambda$ is obliquely incident on the electromagnetic shield 1a. Lattice points are points forming a plane lattice. A plane lattice is an array of points on a plane, the array being unchanged by parallel displacement in two independent directions over a constant distance each. According to the arrangement at lattice points, the plurality of projecting portions 15 are arranged such that particular positions corresponding to the plurality of projecting portions 15 form a plane lattice. According to the arrangement on parallel lines, the plurality of projecting portions 15 are arranged such that particular linear members corresponding to the plurality of projecting portions 15 form parallel lines. According to the random arrangement, particular positions or linear members corresponding to the plurality of projecting portions 15 are arranged in random. As shown in FIG. 1C, in the electromagnetic shield 1a, arrangement of the projecting portion 15 is, for example, arrangement on parallel lines at regular intervals when the first surface 11 is viewed in plan.

The electromagnetic shield 1a satisfies, for example, at least one requirement selected from the group consisting of the following requirements (II-1) and (II-2). The electromagnetic shield 1a thus configured is likely to exhibit desired shielding performance over a wide area thereof when an electromagnetic wave with a wavelength $\lambda$ is obliquely incident on the electromagnetic shield 1a. In the following requirements, $S_p$ is area of the plurality of projecting portions 15 measured when the first surface 11 or the second surface 12 is viewed in plan. The symbol $S_e$ is area of the entire electromagnetic shield 1a measured when the first surface 11 is viewed in plan. The symbol $S_o$ is area of the entire electromagnetic shield 1a measured when the second surface 12 is viewed in plan.

$$0.2 \leq S_p/S_e \leq 0.8 \qquad \text{(II-1)}$$

$$0.2 \leq S_p/S_o \leq 0.8 \qquad \text{(II-2)}$$

When the electromagnetic shield 1a satisfy the requirement (II-1), $S_p/S_e$ may be 0.25 or more, 0.30 or more, or 0.35 or more. Additionally, $S_p/S_e$ may be 0.75 or less, 0.70 or less, 0.65 or less, or 0.60 or less.

As shown in FIGS. 1A, 1B, and 1C, the first surface 11 and the second surface 12 are parallel to each other in the electromagnetic shield 1a. In this case, a distance $d_i$ between the first surface 11 and the second surface 12 is not limited to a particular value. The distance di is, for example, 1 mm or more and 3 mm or less. In this case, the electromagnetic shield 1a is easily shaped.

The electromagnetic shield 1a is, for example, a resin molded article. In this case, the cost of manufacturing the electromagnetic shield 1a is likely to be low.

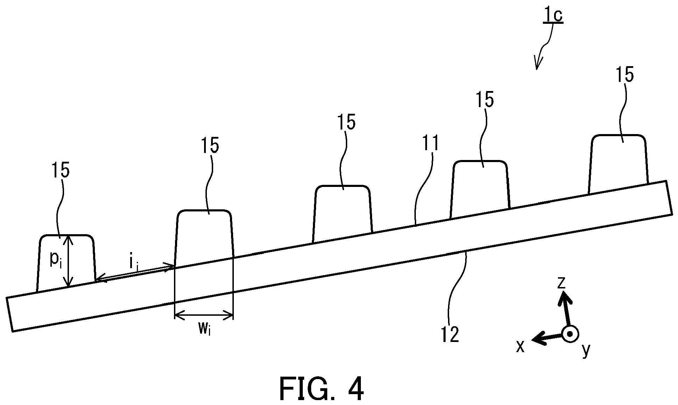

The electromagnetic shield 1a can be modified in various respects. The electromagnetic shield 1a may be modified to an electromagnetic shield 1b as shown in FIG. 3 or an electromagnetic shield 1c as shown in FIG. 4. Each of the electromagnetic shield 1b and the electromagnetic shield 1c is configured in the same manner as the electromagnetic shield 1a unless otherwise described. The components of the electromagnetic shield 1b and the electromagnetic shield 1c that correspond to the components of the electromagnetic shield 1a are denoted by the same reference characters, and detailed descriptions of such components are omitted. The description given for the electromagnetic shield 1a applies to the electromagnetic shields 1b and 1c, unless there is technical inconsistency.

As shown in FIG. 3, in the electromagnetic shield 1b, each of the plurality of projecting portions 15 can be square when the first surface 11 is viewed in plan. Moreover, the plurality of projecting portions 15 are arranged at lattice points of a parallelogram lattice. The electromagnetic shield 1b thus configured is likely to exhibit desired shielding performance when an electromagnetic wave is obliquely incident on the electromagnetic shield 1b from various directions.

As shown in FIG. 4, in the electromagnetic shield 1c, the plurality of projecting portions 15 may project in a direction inclined with respect to a direction parallel to the first surface 11 and a direction perpendicular to the first surface 11. The electromagnetic shield 1c thus configured is likely to exhibit desired shielding performance upon oblique incidence of an electromagnetic wave even in the case where the electromagnetic shield 1c needs to be shaped such that the first surface 11 is slanted.

In the electromagnetic shields 1a, 1b, and 1c, an interaction occurring between the electromagnetic shield and an electromagnetic wave due to blocking of the electromagnetic wave is not limited to a particular interaction. Each of the electromagnetic shields 1a, 1b, and 1c, for example, transmits at least a portion of a radio wave incident on the first surface 11 and allows a scattered radio wave to emerge from the second surface 12. In other words, each of the electromagnetic shields 1a, 1b, and 1c can function as a radio-wave transmitting-scattering body. Because of this, a simple configuration capable of blocking an electromagnetic wave that is obliquely incident thereon is more easily achieved.

Each of the electromagnetic shields 1a, 1b, and 1c has a scattering ratio of, for example, 0.1% or more. The term "scattering ratio" refers to a ratio of an intensity of a particular transmitted-scattered wave to an intensity of a straight transmitted wave emerging from the second surface 12, the intensities being measured when an electromagnetic wave is incident on the first surface 11 at a given incident angle. The scattering ratio is determined, for example, by the following equation (1). "Intensity of transmitted-scattered wave" in the equation (1) is, for example, the sum of intensities measured for a transmitted-scattered wave at scattering angles of $(15 \times k)°$. The term "scattering angle" refers to an angle between an emergent direction of a straight transmitted wave and an emergent direction of a transmitted-scattered wave. The symbol k represents an integer of 1 to n. For example, n is 8 at an incident angle of 45°, n is 7 at an incident angle of 60°, and n is 6 at an incident angle of 75°.

$$\text{Scattering ratio} = \text{Intensity of transmitted-scattered wave/Intensity of straight transmitted wave} \qquad \text{Equation (1)}$$

The intensity of the transmitted-scattered wave and the intensity of the straight transmitted wave can be determined with reference to Japanese Industrial Standards (JIS) R 1679: 2007, for example, by allowing an electromagnetic wave to be incident on the first surface 11 at a given incident angle and measuring a transmission loss in a straight direction and a transmission loss at a given scattering angle. Each transmission loss is expressed by the following equation (2). In the equation (2), Pi is a received electric power, and $P_0$ is a transmitted electric power. $|P_i/P_0|$ corresponds to the intensity of a transmitted wave.

$$\text{Transmission loss} = |10\text{Log}(P_i/P_0)| \qquad \text{Equation (2)}$$

The scattering ratio of each of the electromagnetic shields 1a, 1b, and 1c may be 1% or more, 5% or more, 10% or more, 20% or more, 50% or more, 100% or more, 150% or more, or 200% or more.

EXAMPLES

The present invention will be described hereinafter in more details by examples. The present invention is not limited to the examples given below.

[Relative permittivity]

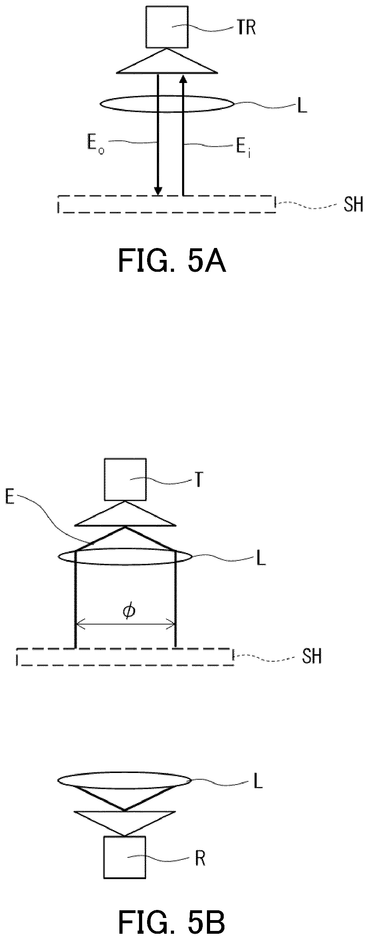

Return losses of a 2.0 mm-thick flat polypropylene (PP) plate at 70 to 90 GHz were measured using a radio transceiver EAS02 manufactured by KEYCOM Corporation in the following procedure with reference to Japanese Industrial Standards (JIS) R 1679: 2007. A sample holder SH, a millimeter-wave lens L, and a transceiver TR were disposed as shown in FIG. 5A, and transmission and reception of radio waves was performed with a metal plate made of stainless steel disposed on the sample holder SH. The metal plate had a diameter of 150 mm and a thickness of 2 mm. A state where a radio wave was all reflected by the metal plate and the return loss was 0 dB was used to determine a level that serves as a reference level for measurement of return loss obtained by perpendicular incidence of a radio wave on the flat PP resin plate. Then, the flat PP resin plate was disposed on the sample holder SH instead of the metal plate, transmission and reception of radio waves was performed, and return losses were measured.
Next, transmission losses of the above flat PP resin plate at 70 to 90 GHz were measured with reference to JIS R 1679: 2007. A measurement system as shown in FIG. 5B was used in this measurement. In this measurement system, a sample holder SH, a millimeter-wave lens L, a transmitter T, and a receiver R were disposed as shown in FIG. 5B. The sample holder SH is irradiated with a radio wave E transmitted by the transmitter T and adjusted to have a diameter (beam diameter) of 30 mm by the millimeter-wave lens L. Transmission and reception of the radio wave E was performed without anything on the sample holder SH, and a state where the transmission loss was 0 dB (the radio wave was all transmitted) was used to determine a reference level for measurement of transmission losses obtained by incidence perpendicular to a surface of the above flat PP resin plate. Then, after the flat PP resin plate was set on the sample holder SH, the receiver R was disposed such that the transmitter T and the receiver R were in a straight line in a direction perpendicular to this flat plate. In this condition, transmission and reception of the radio wave E with a wavelength $\lambda$ was performed, and transmission losses were measured. Each transmission loss is expressed by the absolute value of a value calculated by the following expression (3). In the expression (3), $P_i$ is received electric power, and $P_0$ is transmitted electric power.

$$|10\text{Log}(P_i/P_0)| \qquad \text{Expression (3)}$$

An impedance Z and a propagation constant $\gamma$ of the material are expressed by the following equations (4) and (5). In the equations (4) and (5), $Z_0$ is the impedance of air. The symbol $\mu_r$ is the relative magnetic permeability of the material, and a relation $\mu_r = \mu_r' - j\mu_r'$ is established. The symbol $\varepsilon_r$ is the relative permittivity of the material, and a relation $\varepsilon_r = \varepsilon_r' - j\varepsilon_r''$ is established. The symbol $\lambda$ is the wavelength of a radio wave. The symbol j is the imaginary unit.

$$Z = Z_0(\mu_r/\varepsilon_r)^{0.5} \qquad \text{Equation (4)}$$

$$\gamma = (j2\pi/\lambda)\varepsilon_r^{0.5}\mu_r^{0.5} \qquad \text{Equation (5)}$$

Assuming that the object has a thickness of t, the return loss and the transmission loss are expressed by the following equations (6) and (7) from the above impedance Z and the above propagation constant $\gamma$ according to the transmission line theory. In the equations (6) and (7), relations $A = \cosh(\gamma t)$, $B = Z\sinh(\gamma t)$, $C = (1/Z)\sinh(\gamma t)$, $D = \cosh(\gamma t)$ are established.

$$\text{Transmission loss (dB)} = 20\text{Log}\{2/(A + B/Z_0 + CZ_0 + D)\} \qquad \text{Equation (6)}$$

$$\text{Return loss (dB)} = 20\text{Log}\{(A + B/Z_0 - CZ_0 - D)/(A + B/Z_0 + CZ_0 + D) \quad \text{Equation (7)}$$

Predicted values of the relative magnetic permeability $\mu_r$ and the relative permittivity $\varepsilon_r$ were substituted into the equations (4) and (5). On the basis of the resulting values Z and $\gamma$ and the thickness, 2.0 mm, of the flat PP resin plate, return losses and transmission losses at 70 to 90 GHz were calculated by the equations (6) and (7).

Curve fitting by the least-squares method was performed using a curve of the return losses calculated by the actual values and a curve of the return losses calculated by the above equations (4), (5), and (7). In addition, curve fitting by the least-squares method was performed using a curve of the transmission losses calculated by the actual values and a curve of the transmission losses calculated by the above equations (4), (5), and (6). A possible relative permittivity $\varepsilon_r$ of the PP was determined thereby. According to the result, the real part $\varepsilon'$ and the imaginary part $\varepsilon''$ of the relative permittivity of the PP were respectively 2.30 and 0.00.

[Electromagnetic field analysis]

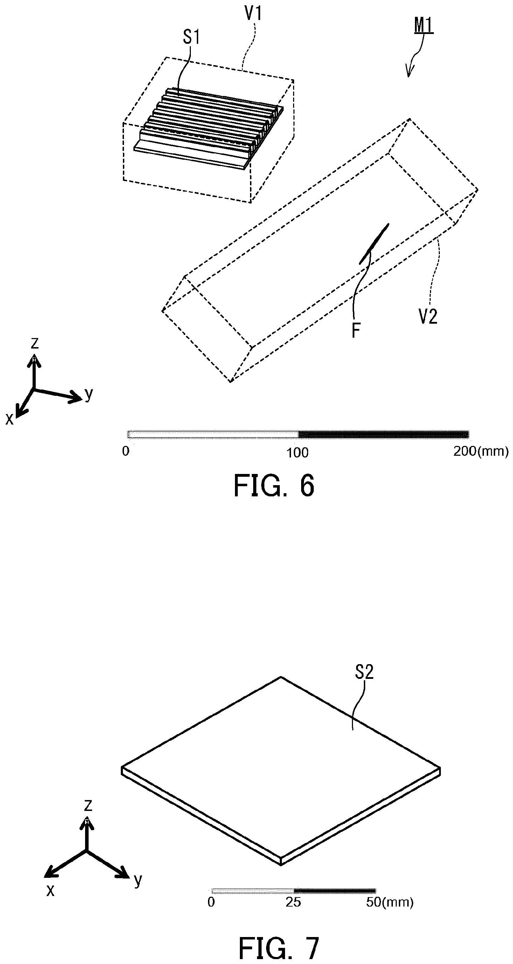

Electromagnetic field analysis of an analysis model M1 shown in FIG. 6 was performed using electromagnetic field analysis software HFSS "Version. 2021R1" manufactured by Ansys. A calculation space V1 and a calculation space V2 are defined in the analysis model M1. An electric field strength in the calculation space V1 and that of the calculation space V2 were determined for the analysis model M1 by numerically solving Maxwell's equations. The finite element method was applied inside these calculation spaces, while the method of moments was applied on boundaries of these calculation spaces.

There was an evaluation object S1 in the calculation space V1. On the basis of the relative permittivity measurement result for the above PP, the real part $\varepsilon'$ and the imaginary part $\varepsilon''$ of the relative permittivity of a portion of the evaluation object S1 were set to 2.30 and 0.00, respectively. Additionally, as shown in Tables 1 to 3, the real parts $\varepsilon'$ of other portions of the evaluation object S1 were set to 1.50 to 1.90 for comparison. The evaluation object S1 was in the shape of a plate having a plurality of projecting portions. In the evaluation object S1, the plurality of projecting portions were provided on one of the principal surfaces of the flat plate, which were in the shape of a square 70 mm on a side in plan view and had a thickness of 2.5 mm, the projecting portions forming projecting strips arranged at regular intervals on parallel straight lines in plan view.

Sides of each projecting portion were inclined at 3° to a plane perpendicular to the one principal surface of the flat plate, the plane being parallel to the above parallel straight lines. Each projecting portion narrowed toward the projecting direction of the projecting portion. Corners of the top portion of the projecting portion were formed at a curvature radius of 0.5 mm. The projection length $p_i$ of the projecting portion of the evaluation object S1, the interval $i_i$ between the projecting portions in a direction parallel to the one principal surface of the flat plane, and the width $w_i$ of the projecting portion on the boundary between the one principal surface of the flat plane and the projecting portion were adjusted as shown in Table 1 to produce a plurality of the evaluation targets S1. Moreover, a ratio $S_p/S_e$ of the area $S_p$ of the plurality of projecting portions to the area $S_e$ of a whole region where the plurality of projecting portions were present on the one principal surface was as shown in Tables 1 to 3, the areas $S_p$ and $S_e$ being measured when the one principal surface is viewed in plane. The other principal surface of the evaluation object S1 was flat.

Electric field strengths in the calculation space V1 and the calculation space V2 were calculated by allowing a TM wave having a frequency (wavelength $\lambda$: about 3.919 mm) of 76.5 GHz and a diameter (beam diameter) of 30 mm to be incident on the evaluation object S1 at incident angles of 45°, 60°, and 75° to the one principal surface, which had the plurality of projecting portions, of the evaluation object S1 or the other principal surface, which was flat, of the evaluation object S1. An amplitude direction of the electric field of the TM wave had a component parallel to a longitudinal direction of the projecting strips formed of the projecting portions. On the other hand, the amplitude direction of the electric field of the TM wave had no components parallel to the one principal surface of the flat plate and perpendicular to the longitudinal direction of the projecting strips formed of the projecting portions.

The calculation space V2 was apart from the evaluation object S1, and there was a receiving plane F in the calculation space V2. The receiving plane F was a 30 mm-diameter circle, and there was an end point of a line segment at the center of the circle, the line segment extending from an incident point of the TM wave on the evaluation object S1 in a direction parallel to an incident direction of the TM wave, the line segment intersecting with the other principal surface or the one principal surface. A distance between the center of the receiving plane F and the evaluation object S1 was set to 120 mm. A point of intersection of the above line segment with the other principal surface of the evaluation object S1 was defined as a point of origin. The incident point was located in a straight line where the center of the receiving plane F and the point of origin were present.

A transmission loss T [dB] was determined by the following equation (8) on the basis of calculation values of a transmitted electric power $P_{T\theta}$ [W] of the TM wave and a received electric power $P_{R\theta}$ [W] of an electromagnetic wave on the receiving plane F, the calculation values being measured when the TM wave was incident on the evaluation object S1 at each incident angle $\theta$. The electric power of an electromagnetic wave received on the receiving plane F when the TM wave was transmitted with no evaluation object disposed in an analysis model was assumed to be the transmitted electric power $P_{T\theta}$ [W]. Tables 1 to 4 show the results. For each of Analysis Nos. 2 to 29, 31 to 58, and 60 to 81 in Tables 1 to 3, the electric field strength obtained by allowing the TM wave to be incident on the one principal surface of the evaluation object S1 with the plurality of projecting portions was calculated. For each of Analysis No. 82 to 84 in Table 4, the electric field strength obtained by allowing the TM wave to be incident on the other, flat, principal surface of the evaluation object S1 was calculated. In terms of disposition, the evaluation objects S1 in the calculation spaces V1 of Analysis No. 82, No. 83, and No. 84 were 180-degree opposites of the evaluation objects S1 in the calculation spaces V1 of Analysis No. 28, No. 57, and No. 81, respectively.

$$T = |10Log(P_{R\theta}/P_{T\theta})| \qquad \text{Equation (8)}$$

An analysis model M2 was produced in the same manner as for the analysis model M1, except that an evaluation object S2 as shown in FIG. 7 was used instead of the evaluation object S1. The evaluation object S2 was in the shape of a square 70 mm on a side in plan view and had a thickness of 2.5 mm. Projecting portions were on neither principal surface of the evaluation object S2, and both principal surfaces were flat. The real part and the imaginary part of the relative permittivity of the evaluation object S2 were set to 2.30 and 0.00, respectively.

Electric field strengths in the calculation space V1 and the calculation space V2 were calculated by allowing a TM wave having a frequency (wavelength $\lambda$: about 3.919 mm) of 76.5 GHz and a diameter (beam diameter) of 30 mm to be incident on the evaluation object S2 at incident angles of 45°, 60°, and 75° to a plurality of one principal surfaces of the evaluation object S2. A transmission loss T [dB] was determined by the above equation (8) on the basis of calculation values of a transmitted electric power $P_{T\theta}$ [W] of the TM wave and a received electric power $P_{R\theta}$ [W] of an electromagnetic wave on the receiving plane F, the calculation values being measured when the TM wave was incident on the evaluation object S2 at each incident angle $\theta$. Tables 1 to 3 show the results. Analysis Nos. 1, 30, and 59 in Tables 1 to 3 show the analysis conditions and the analysis results of the analysis model M2 including the evaluation object S2.

As shown in Tables 1 to 3, the transmission loss T was less than 5 dB in Analysis Nos. 1, 30, and 59 concerning the analysis model M2 including the evaluation object S2. Additionally, the transmission loss T was less than 5 dB in Analysis Nos. 2, 10, 32, 36, and 38 to 40 where the real part of the relative permittivity of the evaluation object S1 is less than 2.0. It is suggested that in the case of the analysis model M1 in which the evaluation object S1 has the plurality of projecting portions, the transmission loss T can be 5 dB or more by adjusting the relative permittivity and the dimensions of the projecting portions.

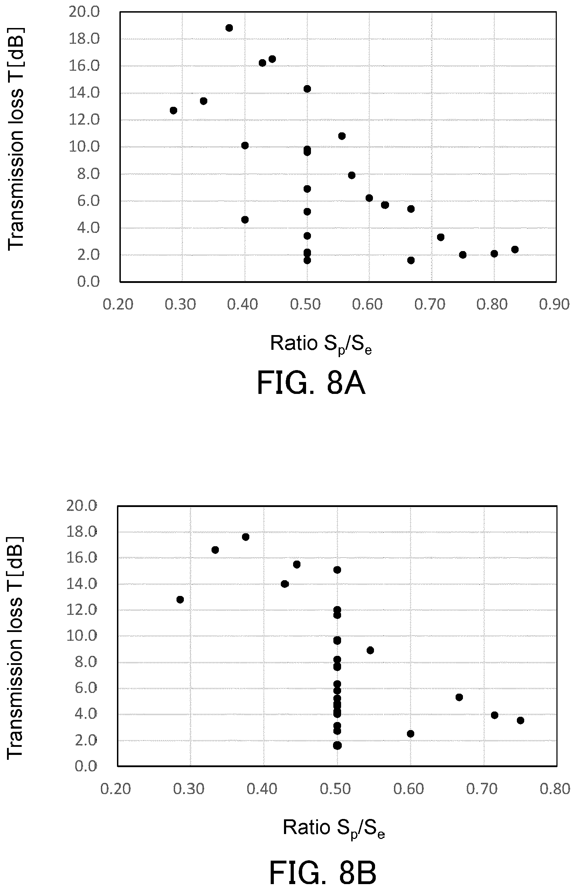

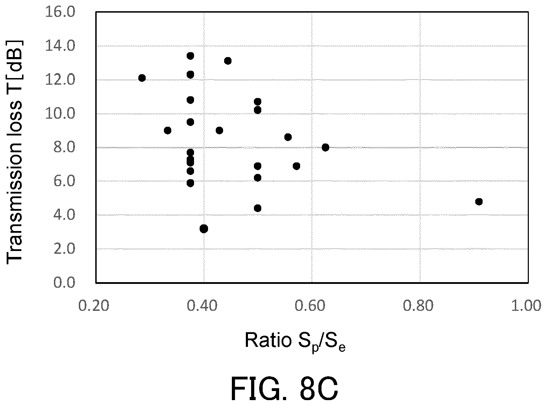

FIG. 8A shows a graph of the relation between the transmission loss T and the ratio $S_p/S_e$ for Analysis Nos. 2 to 28. FIG. 8B shows a graph of the relation between the transmission loss T and the ratio $S_p/S_e$ for Analysis Nos. 29 and 31 to 57. FIG. 8C shows a graph of the relation between the transmission loss T and the ratio $S_p/S_e$ for Analysis Nos. 58 and 60 to 81. FIG. 8A to FIG. 8C suggest that the smaller the ratio $S_p/S_e$ is, the more likely the transmission loss T is to be large.

A first aspect of the present invention provides an electromagnetic shield including:

a dielectric, wherein
the electromagnetic shield has a first surface and a second surface, the first surface being configured to allow an electromagnetic wave to be incident on the first surface, the second surface being configured to allow at least a portion of the electromagnetic wave incident on the first surface to emerge from the second surface, and
when an electromagnetic wave $W\epsilon nn$ having at least one frequency in a range of 10 GHz to 300 GHz is transmitted to be incident on the first surface at incident angles of 45°, 60°, and 75°, the electromagnetic shield satisfies at least one first requirement selected from the group consisting of (I-1), (I-2), and (I-3) below:

$$|10Log(P_{R45}/P_{T45})| \geq 5.0 \text{ [dB]} \qquad (I-1);$$

$$|10Log(P_{R60}/P_{T60})| \geq 5.0 \text{ [dB]} \qquad (I-2);$$

and

$$|10\mathrm{Log}(P_{R75}/P_{T75})| \geq 5.0 \text{ [dB]} \qquad (I\text{-}3),$$

in the first requirements,

$P_{T45}$ is an electric power [W] of the electromagnetic wave $W_{EM}$ transmitted such that the incident angle is 45°,

$P_{R45}$ is an electric power [W] of an electromagnetic wave received on a receiving plane when the electromagnetic wave $W_{EM}$ is transmitted such that the incident angle is 45°, the receiving plane including an end point of a first line segment extending from an incident point of the electromagnetic wave $W_{EM}$ on the electromagnetic shield toward an outside of the electromagnetic shield in a direction parallel to an incident direction of the electromagnetic wave $W_{EM}$, the first line segment intersecting with the second surface, the end point being located in the outside,

$P_{T60}$ is an electric power [W] of the electromagnetic wave $W_{EM}$ transmitted such that the incident angle is 60°,

$P_{R60}$ is an electric power [W] of an electromagnetic wave received on a receiving plane when the electromagnetic wave $W_{EM}$ is transmitted such that the incident angle is 60°, the receiving plane including an end point of a second line segment extending from the incident point of the electromagnetic wave $W_{EM}$ on the electromagnetic shield toward the outside of the electromagnetic shield in a direction parallel to an incident direction of the electromagnetic wave $W_{EM}$, the second line segment intersecting with the second surface, the end point being located in the outside,

$P_{T75}$ is an electric power [W] of the electromagnetic wave $W_{EM}$ transmitted such that the incident angle is 75°, and

$P_{R75}$ is an electric power [W] of an electromagnetic wave received on a receiving plane when the electromagnetic wave $W_{EM}$ is transmitted such that the incident angle is 75°, the receiving plane including an end point of a third line segment extending from the incident point of the electromagnetic wave $W_{EM}$ on the electromagnetic shield toward the outside of the electromagnetic shield in a direction parallel to an incident direction of the electromagnetic wave $W_{EM}$, the third line segment intersecting with the second surface, the end point being located in the outside.

A second aspect of the present invention provides the electromagnetic shield according to the first aspect, wherein the electromagnetic shield is free of an electrically conductive portion.

A third aspect of the present invention provides the electromagnetic shield according to the first aspect or the second aspect, wherein an imaginary part $\varepsilon''$ of a relative permittivity of the dielectric at at least one frequency in a range of 10 GHz to 300 GHz is 0.1 or less.

A fourth aspect of the present invention provides the electromagnetic shield according to any one of the first aspect to the third aspect, wherein a real part $\varepsilon'$ of a relative permittivity of the dielectric at at least one frequency in a range of 10 GHz to 300 GHz is 2.0 to 4.0.

A fifth aspect of the present invention provides the electromagnetic shield according to any one of the first aspect to the fourth aspect, wherein the electromagnetic shield satisfies both the requirement (I-1) and the requirement (I-2).

A sixth aspect of the present invention provides the electromagnetic shield according to any one of the first aspect to the fifth aspect, including a plurality of projecting portions projecting from the first surface in a direction away from the second surface or from the second surface in a direction away from the first surface.

A seventh aspect of the present invention provides the electromagnetic shield according to the sixth aspect, wherein

the electromagnetic shield is capable of shielding against an electromagnetic wave with a wavelength $\lambda$, and
at least one of projection lengths $p_i$ of the plurality of projecting portions satisfies a requirement $0.25\lambda \leq p_i \leq 1.3\lambda$.

An eighth aspect of the present invention provides the electromagnetic shield according to the sixth aspect or the seventh aspect, wherein

the electromagnetic shield is capable of shielding against an electromagnetic wave with a wavelength $\lambda$, and
at least one of widths $w_i$ of the plurality of projecting portions satisfies a requirement $0.51\lambda \leq w_i \leq 1.6\lambda$.

A ninth aspect of the present invention provides the electromagnetic shield according to any one of the sixth aspect to the eighth aspect, wherein

the electromagnetic shield is capable of shielding against an electromagnetic wave with a wavelength $\lambda$, and
an interval $i_i$ between the projecting portions adjacent to each other satisfies a requirement $0.51\lambda \leq i_i \leq 1.6\lambda$.

A tenth aspect of the present invention provides the electromagnetic shield according to any one of the sixth aspect to the ninth aspect, wherein the projecting portion has a shape of at least one selected from the group consisting of a circle, a triangle, a quadrilateral, and a polygon having five or more corners when the first surface or the second surface is viewed in plan.

An eleventh aspect of the present invention provides the electromagnetic shield according to the tenth aspect, wherein arrangement of the plurality of projecting portions is at least one selected from the group consisting of arrangement at lattice points, arrangement on parallel lines, and random arrangement when the first surface or the second surface is viewed in plan.

A twelfth aspect of the present invention provides the electromagnetic shield according to any one of the sixth aspect to the eleventh aspect, wherein

the electromagnetic shield satisfies at least one second requirement selected from the group consisting of the following requirements (II-1) and (II-2):

$$0.2 \leq S_p/S_e \leq 0.8 \qquad \text{(II-1)};$$

and

$$0.2 \leq S_p/S_o \leq 0.8 \qquad \text{(II-2)},$$

in the second requirements,
$S_p$ is area of the plurality of projecting portions measured when the first surface or the second surface is viewed in plan,
$S_e$ is area of the entire electromagnetic shield measured when the first surface is viewed in plan, and
$S_o$ is area of the entire electromagnetic shield measured when the second surface is viewed in plan.

[Table 1]

| Analysis No. | Real part $\varepsilon'$ of relative permittivity | Imaginary part $\varepsilon''$ of relative permittivity | Form of evaluation object | Incident angle $\theta$ of TM wave | Dimensions regarding projecting portion | | | $p_i/\lambda$ | $w_i/\lambda$ | $i_i/\lambda$ | $S_p/S_e$ | Transmission loss T [dB] |
| | | | | | Projection length $p_i$ [mm] | Width $w_i$ [mm] | Interval $l_i$ [mm] | | | | | |
|---|---|---|---|---|---|---|---|---|---|---|---|---|
| 1 | 2.30 | 0.00 | Flat plate | 45° | 0 | 0 | 0 | 0 | 0 | 0 | - | 1.3 |
| 2 | 1.90 | 0.00 | Strips | 45° | 1.0 | 4.0 | 4.0 | 0.26 | 1.02 | 1.02 | 0.50 | 1.6 |
| 3 | 2.30 | 0.00 | Strips | 45° | 3.0 | 2.0 | 1.0 | 0.77 | 0.51 | 0.26 | 0.67 | 1.6 |
| 4 | 2.30 | 0.00 | Strips | 45° | 3.0 | 3.0 | 1.0 | 0.77 | 0.77 | 0.26 | 0.75 | 2.0 |
| 5 | 2.30 | 0.00 | Strips | 45° | 3.0 | 4.0 | 1.0 | 0.77 | 1.02 | 0.26 | 0.80 | 2.1 |
| 6 | 2.30 | 0.00 | Strips | 45° | 3.0 | 2.0 | 2.0 | 0.77 | 0.51 | 0.51 | 0.50 | 2.1 |
| 7 | 2.30 | 0.00 | Strips | 45° | 1.0 | 4.0 | 4.0 | 0.26 | 1.02 | 1.02 | 0.50 | 2.2 |
| 8 | 2.30 | 0.00 | Strips | 45° | 3.0 | 5.0 | 1.0 | 0.77 | 1.28 | 0.26 | 0.83 | 2.4 |
| 9 | 2.30 | 0.00 | Strips | 45° | 3.0 | 5.0 | 2.0 | 0.77 | 1.28 | 0.51 | 0.71 | 3.3 |
| 10 | 1.90 | 0.00 | Strips | 45° | 2.0 | 4.0 | 4.0 | 0.51 | 1.02 | 1.02 | 0.50 | 3.4 |
| 11 | 2.30 | 0.00 | Strips | 45° | 4.0 | 4.0 | 6.0 | 1.02 | 1.02 | 1.53 | 0.40 | 4.6 |
| 12 | 2.30 | 0.00 | Strips | 45° | 2.0 | 4.0 | 4.0 | 0.51 | 1.02 | 1.02 | 0.50 | 5.2 |
| 13 | 2.30 | 0.00 | Strips | 45° | 3.0 | 4.0 | 2.0 | 0.77 | 1.02 | 0.51 | 0.67 | 5.4 |
| 14 | 2.30 | 0.00 | Strips | 45° | 3.0 | 5.0 | 3.0 | 0.77 | 1.28 | 0.77 | 0.63 | 5.7 |
| 15 | 2.30 | 0.00 | Strips | 45° | 3.0 | 3.0 | 2.0 | 0.77 | 0.77 | 0.51 | 0.60 | 6.2 |
| 16 | 2.30 | 0.00 | Strips | 45° | 5.0 | 4.0 | 4.0 | 1.28 | 1.02 | 1.02 | 0.50 | 6.9 |
| 17 | 2.30 | 0.00 | Strips | 45° | 3.0 | 4.0 | 3.0 | 0.77 | 1.02 | 0.77 | 0.57 | 7.9 |
| 18 | 2.30 | 0.00 | Strips | 45° | 4.0 | 4.0 | 4.0 | 1.02 | 1.02 | 1.02 | 0.50 | 9.6 |
| 19 | 2.30 | 0.00 | Strips | 45° | 3.0 | 4.0 | 4.0 | 0.77 | 1.02 | 1.02 | 0.50 | 9.7 |
| 20 | 2.30 | 0.00 | Strips | 45° | 3.0 | 3.0 | 3.0 | 0.77 | 0.77 | 0.77 | 0.50 | 9.8 |
| 21 | 2.30 | 0.00 | Strips | 45° | 3.0 | 2.0 | 3.0 | 0.77 | 0.51 | 0.77 | 0.40 | 10.1 |
| 22 | 2.30 | 0.00 | Strips | 45° | 3.0 | 5.0 | 4.0 | 0.77 | 1.28 | 1.02 | 0.56 | 10.8 |

(continued)

| Analysis No. | Real part ε' of relative permittivity | Imaginary part ε" of relative permittivity | Form of evaluation object | Incident angle θ of TM wave | Dimensions regarding projecting portion | | | $p_i/\lambda$ | $w_i/\lambda$ | $i_i/\lambda$ | $S_p/S_e$ | Transmission loss T [dB] |
| | | | | | Projection length $p_i$ [mm] | Width $w_i$ [mm] | Interval $l_i$ [mm] | | | | | |
|---|---|---|---|---|---|---|---|---|---|---|---|---|
| 23 | 2.30 | 0.00 | Strips | 45° | 3.0 | 2.0 | 5.0 | 0.77 | 0.51 | 1.28 | 0.29 | 12.7 |
| 24 | 2.30 | 0.00 | Strips | 45° | 3.0 | 2.0 | 4.0 | 0.77 | 0.51 | 1.02 | 0.33 | 13.4 |
| 25 | 2.30 | 0.00 | Strips | 45° | 3.0 | 5.0 | 5.0 | 0.77 | 1.28 | 1.28 | 0.50 | 14.3 |
| 26 | 2.30 | 0.00 | Strips | 45° | 3.0 | 3.0 | 4.0 | 0.77 | 0.77 | 1.02 | 0.43 | 16.2 |
| 27 | 2.30 | 0.00 | Strips | 45° | 3.0 | 4.0 | 5.0 | 0.77 | 1.02 | 1.28 | 0.44 | 16.5 |
| 28 | 2.30 | 0.00 | Strips | 45° | 3.0 | 3.0 | 5.0 | 0.77 | 0.77 | 1.28 | 0.38 | 18.8 |

[Table 2]

| Analysis No. | Real part $\varepsilon'$ of relative permittivity | Imaginary part $\varepsilon''$ of relative permittivity | Form of evaluation object | Incident angle $\theta$ of TM wave | Dimensions regarding projecting portion | | | $p_i/\lambda$ | $w_i/\lambda$ | $i_i/\lambda$ | $S_p/S_e$ | Transmission loss T [dB] |
|---|---|---|---|---|---|---|---|---|---|---|---|---|
| | | | | | Projection length $p_i$ [mm] | Width $w_i$ [mm] | Interval $i_i$ [mm] | | | | | |
| 29 | 2.30 | 0.00 | Strips | 60° | 3.0 | 2.0 | 2.0 | 0.77 | 0.51 | 0.51 | 0.50 | 1.6 |
| 30 | 2.30 | 0.00 | Flat plate | 60° | 0 | 0.0 | 0 | 0 | 0 | 0 | - | 1.9 |
| 31 | 2.30 | 0.00 | Strips | 60° | 3.0 | 3.0 | 2.0 | 0.77 | 0.77 | 0.51 | 0.60 | 2.5 |
| 32 | 1.90 | 0.00 | Strips | 60° | 1.0 | 4.0 | 4.0 | 0.26 | 1.02 | 1.02 | 0.50 | 2.7 |
| 33 | 2.30 | 0.00 | Strips | 60° | 1.0 | 4.0 | 4.0 | 0.26 | 1.02 | 1.02 | 0.50 | 3.1 |
| 34 | 2.30 | 0.00 | Strips | 60° | 3.0 | 6.0 | 2.0 | 0.77 | 1.53 | 0.51 | 0.75 | 3.5 |
| 35 | 2.30 | 0.00 | Strips | 60° | 3.0 | 5.0 | 2.0 | 0.77 | 1.28 | 0.51 | 0.71 | 3.9 |
| 36 | 1.50 | 0.00 | Strips | 60° | 2.0 | 4.0 | 4.0 | 0.51 | 1.02 | 1.02 | 0.50 | 4.0 |
| 37 | 2.30 | 0.00 | Strips | 60° | 5.0 | 4.0 | 4.0 | 1.28 | 1.02 | 1.02 | 0.50 | 4.2 |
| 38 | 1.60 | 0.00 | Strips | 60° | 2.0 | 4.0 | 4.0 | 0.51 | 1.02 | 1.02 | 0.50 | 4.6 |
| 39 | 1.70 | 0.00 | Strips | 60° | 2.0 | 4.0 | 4.0 | 0.51 | 1.02 | 1.02 | 0.50 | 4.8 |
| 40 | 1.80 | 0.00 | Strips | 60° | 2.0 | 4.0 | 4.0 | 0.51 | 1.02 | 1.02 | 0.50 | 5.2 |
| 41 | 2.30 | 0.00 | Strips | 60° | 3.0 | 4.0 | 2.0 | 0.77 | 1.02 | 0.51 | 0.67 | 5.3 |
| 42 | 1.90 | 0.00 | Strips | 60° | 2.0 | 4.0 | 4.0 | 0.51 | 1.02 | 1.02 | 0.50 | 5.8 |
| 43 | 2.30 | 0.00 | Strips | 60° | 1.5 | 4.0 | 4.0 | 0.38 | 1.02 | 1.02 | 0.50 | 6.3 |
| 44 | 2.30 | 0.00 | Strips | 60° | 4.5 | 4.0 | 4.0 | 1.15 | 1.02 | 1.02 | 0.50 | 7.6 |
| 45 | 2.30 | 0.00 | Strips | 60° | 3.0 | 3.0 | 3.0 | 0.77 | 0.77 | 0.77 | 0.50 | 7.7 |
| 46 | 2.30 | 0.00 | Strips | 60° | 3.0 | 5.0 | 5.0 | 0.77 | 1.28 | 1.28 | 0.50 | 8.2 |
| 47 | 2.30 | 0.00 | Strips | 60° | 3.0 | 6.0 | 5.0 | 0.77 | 1.53 | 1.28 | 0.55 | 8.9 |
| 48 | 2.30 | 0.00 | Strips | 60° | 2.0 | 4.0 | 4.0 | 0.51 | 1.02 | 1.02 | 0.50 | 9.6 |
| 49 | 2.30 | 0.00 | Strips | 60° | 4.0 | 4.0 | 4.0 | 1.02 | 1.02 | 1.02 | 0.50 | 9.7 |
| 50 | 2.30 | 0.00 | Strips | 60° | 3.5 | 4.0 | 4.0 | 0.89 | 1.02 | 1.02 | 0.50 | 11.6 |

| Analysis No. | Real part ε' of relative permittivity | Imaginary part ε" of relative permittivity | Form of evaluation object | Incident angle θ of TM wave | Dimensions regarding projecting portion | | | $p_i/\lambda$ | $w_i/\lambda$ | $i_i/\lambda$ | $S_p/S_e$ | Transmission loss T [dB] |
|---|---|---|---|---|---|---|---|---|---|---|---|---|
| | | | | | Projection length $p_i$ [mm] | Width $w_i$ [mm] | Interval $i_i$ [mm] | | | | | |
| 51 | 2.30 | 0.00 | Strips | 60° | 2.5 | 4.0 | 4.0 | 0.64 | 1.02 | 1.02 | 0.50 | 12.0 |
| 52 | 2.30 | 0.00 | Strips | 60° | 3.0 | 2.0 | 5.0 | 0.77 | 0.51 | 1.28 | 0.29 | 12.8 |
| 53 | 2.30 | 0.00 | Strips | 60° | 3.0 | 3.0 | 4.0 | 0.77 | 0.77 | 1.02 | 0.43 | 14.0 |
| 54 | 2.30 | 0.00 | Strips | 60° | 3.0 | 4.0 | 4.0 | 0.77 | 1.02 | 1.02 | 0.50 | 15.1 |
| 55 | 2.30 | 0.00 | Strips | 60° | 3.0 | 4.0 | 5.0 | 0.77 | 1.02 | 1.28 | 0.44 | 15.5 |
| 56 | 2.30 | 0.00 | Strips | 60° | 3.0 | 3.0 | 6.0 | 0.77 | 0.77 | 1.53 | 0.33 | 16.6 |
| 57 | 2.30 | 0.00 | Strips | 60° | 3.0 | 3.0 | 5.0 | 0.77 | 0.77 | 1.28 | 0.38 | 17.6 |

[Table 3]

| Analysis No. | Real part ε' of relative permittivity | Imaginary part ε" of relative permittivity | Form of evaluation object | Incident angle θ of TM wave | Dimensions regarding projecting portion | | | $p_i/\lambda$ | $w_i/\lambda$ | $i_i/\lambda$ | $S_p/S_e$ | Transmission loss T [dB] |
|---|---|---|---|---|---|---|---|---|---|---|---|---|
| | | | | | Projection length $p_i$ [mm] | Width $w_i$ [mm] | Interval $i_i$ [mm] | | | | | |
| 58 | 2.30 | 0.00 | Strips | 75° | 2.0 | 2.0 | 3.0 | 0.51 | 0.51 | 0.77 | 0.40 | 3.2 |
| 59 | 2.30 | 0.00 | Flat plate | 75° | 0.0 | 0.0 | 0.0 | 0 | 0 | 0 | - | 3.9 |
| 60 | 2.30 | 0.00 | Strips | 75° | 2.0 | 3.0 | 3.0 | 0.51 | 0.77 | 0.77 | 0.50 | 4.4 |
| 61 | 2.30 | 0.00 | Strips | 75° | 3.0 | 5.0 | 0.5 | 0.77 | 1.28 | 0.13 | 0.91 | 4.8 |
| 62 | 2.30 | 0.00 | Strips | 75° | 1.0 | 3.0 | 5.0 | 0.26 | 0.77 | 1.28 | 0.38 | 5.9 |
| 63 | 1.90 | 0.00 | Strips | 75° | 1.0 | 4.0 | 4.0 | 0.26 | 1.02 | 1.02 | 0.50 | 6.2 |
| 64 | 2.30 | 0.00 | Strips | 75° | 4.0 | 3.0 | 5.0 | 1.02 | 0.77 | 1.28 | 0.38 | 6.6 |
| 65 | 2.30 | 0.00 | Strips | 75° | 2.0 | 4.0 | 3.0 | 0.51 | 1.02 | 0.77 | 0.57 | 6.9 |
| 66 | 1.90 | 0.00 | Strips | 75° | 2.0 | 4.0 | 4.0 | 0.51 | 1.02 | 1.02 | 0.50 | 6.9 |
| 67 | 2.30 | 0.00 | Strips | 75° | 5.0 | 3.0 | 5.0 | 1.28 | 0.77 | 1.28 | 0.38 | 7.1 |
| 68 | 2.30 | 0.00 | Strips | 75° | 4.5 | 3.0 | 5.0 | 1.15 | 0.77 | 1.28 | 0.38 | 7.3 |
| 69 | 2.30 | 0.00 | Strips | 75° | 1.5 | 3.0 | 5.0 | 0.38 | 0.77 | 1.28 | 0.38 | 7.7 |
| 70 | 2.30 | 0.00 | Strips | 75° | 2.0 | 5.0 | 3.0 | 0.51 | 1.28 | 0.77 | 0.63 | 8.0 |
| 71 | 2.30 | 0.00 | Strips | 75° | 2.0 | 5.0 | 4.0 | 0.51 | 1.28 | 1.02 | 0.56 | 8.6 |
| 72 | 2.30 | 0.00 | Strips | 75° | 2.0 | 3.0 | 4.0 | 0.51 | 0.77 | 1.02 | 0.43 | 9.0 |
| 73 | 2.30 | 0.00 | Strips | 75° | 2.0 | 2.0 | 4.0 | 0.51 | 0.51 | 1.02 | 0.33 | 9.0 |
| 74 | 2.30 | 0.00 | Strips | 75° | 3.5 | 3.0 | 5.0 | 0.89 | 0.77 | 1.28 | 0.38 | 9.5 |
| 75 | 2.30 | 0.00 | Strips | 75° | 2.0 | 5.0 | 5.0 | 0.51 | 1.28 | 1.28 | 0.50 | 10.2 |
| 76 | 2.30 | 0.00 | Strips | 75° | 2.0 | 4.0 | 4.0 | 0.51 | 1.02 | 1.02 | 0.50 | 10.7 |
| 77 | 2.30 | 0.00 | Strips | 75° | 3.0 | 3.0 | 5.0 | 0.77 | 0.77 | 1.28 | 0.38 | 10.8 |
| 78 | 2.30 | 0.00 | Strips | 75° | 2.0 | 2.0 | 5.0 | 0.51 | 0.51 | 1.28 | 0.29 | 12.1 |
| 79 | 2.30 | 0.00 | Strips | 75° | 2.5 | 3.0 | 5.0 | 0.64 | 0.77 | 1.28 | 0.38 | 12.3 |

| Analysis No. | Real part $\varepsilon'$ of relative permittivity | Imaginary part $\varepsilon''$ of relative permittivity | Form of evaluation object | Incident angle $\theta$ of TM wave | Dimensions regarding projecting portion | | | $p_i/\lambda$ | $w_i/\lambda$ | $i_i/\lambda$ | $S_p/S_e$ | Transmission loss T [dB] |
| --- | --- | --- | --- | --- | --- | --- | --- | --- | --- | --- | --- | --- |
| | | | | | Projection length $p_i$ [mm] | Width $w_i$ [mm] | Interval $i_i$ [mm] | | | | | |
| 80 | 2.30 | 0.00 | Strips | 75° | 2.0 | 4.0 | 5.0 | 0.51 | 1.02 | 1.28 | 0.44 | 13.1 |
| 81 | 2.30 | 0.00 | Strips | 75° | 2.0 | 3.0 | 5.0 | 0.51 | 0.77 | 1.28 | 0.38 | 13.4 |

[Table 4]

| Analysis No. | Real part $\varepsilon'$ of relative permittivity | Imaginary part $\varepsilon''$ of relative permittivity | Form of evaluation object | Incident angle $\theta$ of TM wave | Dimensions regarding projecting portion | | | $p_i/\lambda$ | $w_i/\lambda$ | $i_i/\lambda$ | $S_p/S_e$ | Transmission loss T [dB] |
|---|---|---|---|---|---|---|---|---|---|---|---|---|
| | | | | | Projection length $p_i$ [mm] | Width $w_i$ [mm] | Interval $i_i$ [mm] | | | | | |
| 82 | 2.3 | 0 | Strips | 45 | 3.0 | 3.0 | 5.0 | 0.8 | 0.8 | 1.3 | 0.38 | 18.2 |
| 83 | 2.3 | 0 | Strips | 60 | 3.0 | 3.0 | 5.0 | 0.8 | 0.8 | 1.3 | 0.38 | 17.0 |
| 84 | 2.3 | 0 | Strips | 75 | 2.0 | 3.0 | 5.0 | 0.5 | 0.8 | 1.3 | 0.38 | 13.9 |

**Claims**

1. An electromagnetic shield, comprising

    a dielectric, wherein
    the electromagnetic shield has a first surface and a second surface, the first surface being configured to allow an electromagnetic wave to be incident on the first surface, the second surface being configured to allow at least a portion of the electromagnetic wave incident on the first surface to emerge from the second surface, and when an electromagnetic wave $W\varepsilon nn$ having at least one frequency in a range of 10 GHz to 300 GHz is transmitted to be incident on the first surface at incident angles of 45°, 60°, and 75°, the electromagnetic shield satisfies at least one first requirement selected from the group consisting of (I-1), (I-2), and (I-3) below:

$$|10Log(P_{R45}/P_{T45})| \geq 5.0 \text{ [dB]} \quad \text{(I-1)};$$

$$|10Log(P_{R60}/P_{T60})| \geq 5.0 \text{ [dB]} \quad \text{(I-2)};$$

    and

$$|10Log(P_{R75}/P_{T75})| \geq 5.0 \text{ [dB]} \quad \text{(I-3)},$$

    in the first requirements,
    $P_{T45}$ is an electric power [W] of the electromagnetic wave $W\varepsilon nn$ transmitted such that the incident angle is 45°, $P_{R45}$ is an electric power [W] of an electromagnetic wave received on a receiving plane when the electromagnetic wave $W_{EM}$ is transmitted such that the incident angle is 45°, the receiving plane including an end point of a first line segment extending from an incident point of the electromagnetic wave $W_{EM}$ on the electromagnetic shield toward an outside of the electromagnetic shield in a direction parallel to an incident direction of the electromagnetic wave $W_{EM}$, the first line segment intersecting with the second surface, the end point being located in the outside,
    $P_{T60}$ is an electric power [W] of the electromagnetic wave $W_{EM}$ transmitted such that the incident angle is 60°, $P_{R60}$ is an electric power [W] of an electromagnetic wave received on a receiving plane when the electromagnetic wave $W_{EM}$ is transmitted such that the incident angle is 60°, the receiving plane including an end point of a second line segment extending from the incident point of the electromagnetic wave $W_{EM}$ on the electromagnetic shield toward the outside of the electromagnetic shield in a direction parallel to an incident direction of the electromagnetic wave $W_{EM}$, the second line segment intersecting with the second surface, the end point being located in the outside,
    $P_{T75}$ is an electric power [W] of the electromagnetic wave $W_{EM}$ transmitted such that the incident angle is 75°, and $P_{R75}$ is an electric power [W] of an electromagnetic wave received on a receiving plane when the electromagnetic wave $W_{EM}$ is transmitted such that the incident angle is 75°, the receiving plane including an end point of a third line segment extending from the incident point of the electromagnetic wave $W_{EM}$ on the electromagnetic shield toward the outside of the electromagnetic shield in a direction parallel to an incident direction of the electromagnetic wave $W_{EM}$, the third line segment intersecting with the second surface, the end point being located in the outside.

2. The electromagnetic shield according to claim 1, wherein the electromagnetic shield is free of an electrically conductive portion.

3. The electromagnetic shield according to claim 1 or 2, wherein an imaginary part $\varepsilon''$ of a relative permittivity of the dielectric at at least one frequency in a range of 10 GHz to 300 GHz is 0.1 or less.

4. The electromagnetic shield according to any one of claims 1 to 3, wherein a real part $\varepsilon'$ of a relative permittivity of the dielectric at at least one frequency in a range of 10 GHz to 300 GHz is 2.0 to 4.0.

5. The electromagnetic shield according to any one of claims 1 to 4, wherein the electromagnetic shield satisfies both the requirement (I-1) and the requirement (I-2).

6. The electromagnetic shield according to any one of claims 1 to 5, comprising a plurality of projecting portions projecting from the first surface in a direction away from the second surface or from the second surface in a direction away from the first surface.

7. The electromagnetic shield according to claim 6, wherein

   the electromagnetic shield is capable of shielding against an electromagnetic wave with a wavelength $\lambda$, and at least one of projection lengths $p_i$ of the plurality of projecting portions satisfies a requirement $0.25\lambda \leq p_i \leq 1.3\lambda$.

8. The electromagnetic shield according to claim 6 or 7, wherein

   the electromagnetic shield is capable of shielding against an electromagnetic wave with a wavelength $\lambda$, and at least one of widths $w_i$ of the plurality of projecting portions satisfies a requirement $0.51\lambda \leq w_i \leq 1.6\lambda$.

9. The electromagnetic shield according to any one of claims 6 to 8, wherein

   the electromagnetic shield is capable of shielding against an electromagnetic wave with a wavelength $\lambda$, and an interval $i_i$ between the projecting portions adjacent to each other satisfies a requirement $0.51\lambda \leq i_i \leq 1.6\lambda$.

10. The electromagnetic shield according to any one of claims 6 to 9, wherein the projecting portion has a shape of at least one selected from the group consisting of a circle, a triangle, a quadrilateral, and a polygon having five or more corners when the first surface or the second surface is viewed in plan.

11. The electromagnetic shield according to claim 10, wherein arrangement of the plurality of projecting portions is at least one selected from the group consisting of arrangement at lattice points, arrangement on parallel lines, and random arrangement when the first surface or the second surface is viewed in plan.

12. The electromagnetic shield according to any one of claims 6 to 11, wherein

   the electromagnetic shield satisfies at least one second requirement selected from the group consisting of the following requirements (II-1) and (II-2):

$$0.2 \leq S_p/S_e \leq 0.8 \qquad \text{(II-1)};$$

   and

$$0.2 \leq S_p/S_o \leq 0.8 \qquad \text{(II-2)},$$

   in the second requirements,
   $S_p$ is area of the plurality of projecting portions measured when the first surface or the second surface is viewed in plan,
   $S_e$ is area of the entire electromagnetic shield measured when the first surface is viewed in plan, and
   $S_o$ is area of the entire electromagnetic shield measured when the second surface is viewed in plan.

FIG. 1A

FIG. 1B

FIG. 1C

FIG. 2

FIG. 3

FIG. 4

FIG. 5A

FIG. 5B

FIG. 6

FIG. 7

FIG. 8A

FIG. 8B

FIG. 8C

Europäisches
Patentamt

European
Patent Office

Office européen
des brevets

**EUROPEAN SEARCH REPORT**

Application Number

EP 23 17 8890

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/179142 A1 (NAKAMURA FUMINORI [JP] ET AL) 25 September 2003 (2003-09-25) * paragraph [0033] – paragraph [0040]; figures 1-4 * | 1-12 | INV. H05K9/00 H01Q15/00 |
| X | JP 2004 153135 A (NICHIAS CORP) 27 May 2004 (2004-05-27) * paragraph [0010] – paragraph [0033]; figures 1-6 * | 1-6 | |
| A | US 2014/070982 A1 (INADA TAKAHIRO [JP] ET AL) 13 March 2014 (2014-03-13) * paragraph [0093] – paragraph [0104]; figures 13-14 * | 1-12 | |
| A | JP H09 181474 A (FUJI ELECTROCHEMICAL CO LTD; ASK KK) 11 July 1997 (1997-07-11) * paragraph [0017] – paragraph [0036]; figures 1-17 * | 1-12 | |
| A | JP H08 274492 A (FUJI ELECTROCHEMICAL CO LTD; ASK KK) 18 October 1996 (1996-10-18) * paragraph [0020] – paragraph [0021]; figures 5-7 * | 1-12 | TECHNICAL FIELDS SEARCHED (IPC) H05K H01Q |

The present search report has been drawn up for all claims

| Place of search | Date of completion of the search | Examiner |
|---|---|---|
| The Hague | 2 November 2023 | Seifert, Frank |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 17 8890

This annex lists the patent family members relating to the patent documents cited in  the above-mentioned European search report.
The members are as contained in the European Patent Office EDP file on
The European Patent Office is in no way liable for these particulars which are merely given for the purpose of information.

02-11-2023

| Patent document cited in search report | | Publication date | Patent family member(s) | | Publication date |
|---|---|---|---|---|---|
| US 2003179142 | A1 | 25-09-2003 | DE | 10313353 A1 | 16-10-2003 |
| | | | FR | 2839208 A1 | 31-10-2003 |
| | | | JP | 2003283242 A | 03-10-2003 |
| | | | US | 2003179142 A1 | 25-09-2003 |
| | | | US | 2005156809 A1 | 21-07-2005 |
| JP 2004153135 | A | 27-05-2004 | NONE | | |
| US 2014070982 | A1 | 13-03-2014 | CN | 103703387 A | 02-04-2014 |
| | | | DE | 112012001758 T5 | 06-02-2014 |
| | | | JP | 5696781 B2 | 08-04-2015 |
| | | | JP | WO2012144150 A1 | 28-07-2014 |
| | | | US | 2014070982 A1 | 13-03-2014 |
| | | | WO | 2012144150 A1 | 26-10-2012 |
| JP H09181474 | A | 11-07-1997 | NONE | | |
| JP H08274492 | A | 18-10-1996 | JP | 3546091 B2 | 21-07-2004 |
| | | | JP | H08274492 A | 18-10-1996 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6901629 B

- JP 6901630 B